# EUROPEAN PATENT APPLICATION

(11) **EP 2 790 037 A2**
(43) Date of publication of application: **15.10.2014**
(21) Application number: 14162892.5
(22) Date of filing: 31.03.2014
(51) Int. Cl.: G01V 1/00, G01V 1/20

(54) **Spherical helix projection microseismic network**

(30) Priority: 12.04.2013 FR 1353345
(71) Applicant: CGG Services SA, 91300 Massy (FR)
(72) Inventor: Bardainne, Thomas, 91300 MASSY (FR)
(74) Representative: Regimbeau

(57) **Abstract**

Methods and systems for designing or configuring a microseismic monitoring network are described. The design is based on a regular and homogeneous repartitioning of seismic sensor locations associated with a focal sphere. The methods and systems determine an optimal sampling of the focal sphere of microseismic events and a takeoff angle associated with each of the optimal sampling points. The sampling points are propagated to the surface based on the associated rays and any of a plurality of ray tracing techniques.

## Description

### TECHNICAL FIELD

Embodiments of the subject matter disclosed herein generally relate to methods and systems for seismic network configuration and, more particularly, to mechanisms and techniques to design microseismic networks in order to optimize the coverage of observation of the focal sphere of a microseismic events.

### BACKGROUND

For on-shore seismic recorded data, microseismic networks are used to monitor oil and gas production fields through a process of microseismic monitoring. Microseismic monitoring is the passive observation of very small-scale seismic events, i.e., microseismic events, occurring in the ground and associated with oil and gas production.

Microseismic events occur in part based on oil and gas production operations that change the stress load distribution and/or the volume of the underlying strata. When the stress loads attempt to redistribute the stress within the underlying strata, slip or shear movement will suddenly occur along pre-existing zones of weakness such as faults or fracture networks created in the zone of production operation. The small localized strata failure results in the release of energy in the form of seismic waves, known as microseismic events.

Microseismic networks are seismic networks established to monitor for microseismic events. Microseismic networks typically are placed over operational oil and gas production fields and remain in place for the production life of the field. Microseismic networks can provide information about the efficiency of the recovery from the field and guide production operations in fracturing an existing production field. Microseismic networks, while resembling other seismic networks, are generally smaller based on their purpose of focusing on a known area of a production field or a portion of a production field.

Being a comparatively new area of seismic technology, microseismic network implementation can still benefit from further optimization. For example, paradigms other than a grid pattern for the microseismic network geometry are desired that provide for reducing capital costs associated with microseismic network receiver placement. It is further desired to reduce processing requirements and permitting issues based on using a reduced number of sensors.

Accordingly, it would be desirable to provide systems and methods that avoid the afore-described problems and drawbacks, and which generate microseismic network configurations requiring fewer numbers of sensors for implementation.

### SUMMARY

According to an embodiment, a method, stored in a memory and executing on a processor, for designing a ground surface microseismic network based on a focal sphere bounding a desired volume of seismic events comprises mapping the focal sphere with a spherical helix configured with a first predetermined angular distance between each loop of the spherical helix around the focal sphere surface; selecting a plurality of locations along the spherical helix wherein each of the plurality of locations are separated by a second predetermined angular distance and the plurality of locations are takeoff positions; and projecting the takeoff positions to the surface wherein a takeoff angle, based on each of the takeoff positions, is convolved by propagation to the ground surface and locates a unique sensor position for sensor placement for each of the takeoff positions.

According to another exemplary embodiment, a method, stored in a memory and executing on a processor, for monitoring microseismic events associated with a predefined volume comprises positioning and sizing a focal sphere to encompass the predefined volume; mapping the focal sphere with a spherical helix configured with a first predetermined angular distance between each loop of the spherical helix around the focal sphere surface; selecting a plurality of locations along the spherical helix wherein each of the plurality of locations are separated by a second predetermined angular distance and the plurality of locations are takeoff positions; projecting the takeoff positions to the surface wherein a takeoff angle, based on each of the takeoff positions, is convolved by propagation to the ground surface and locates a unique sensor position for sensor placement for each of the takeoff positions; and configuring a sensor at each of the unique sensor positions and recording the microseismic events.

According to another exemplary embodiment, a node for monitoring microseismic events associated with a predefined spherical volume comprises a plurality of seismic sensors; one or more processors configured to execute computer instructions and a memory configured to store the computer instructions wherein the computer instructions further comprise: a configuration component for determining the positions at the ground surface for placing the plurality of seismic sensors; an input component for collecting seismic data from the plurality of seismic sensors; an engine component for processing the seismic data; and an output component for outputting processed seismic data.

### BRIEF DESCRIPTION OF THE DRAWINGS

The accompanying drawings, which are incorporated in and constitute a part of the specification, illustrate one or more embodiments and, together with the description, explain these embodiments. In the drawings:
Figure 1 shows various aspects of a microseismic monitoring system according to an embodiment;
Figure 2 is a schematic diagram indicating waves generated by a seismic source according to an embodiment;
Figure 3A and 3B illustrate vertical and radial components of recorded data according to an embodiment;
Figure 4 is a schematic diagram illustrating up-going (primary) and down-going (ghost) S-waves and their polarizations according to an embodiment;
Figure 5 is a schematic diagram illustrating primary and ghost components according to an embodiment;
Figure 6 is a schematic diagram of a focal sphere with a spherical helix;
Figure 7 is a schematic diagram of a focal sphere with a spherical helix and takeoff point positions;
Figure 8 is a schematic diagram of a focal sphere with a spherical helix and takeoff point positions indicating predetermined angular distances;
Figure 9 is a schematic diagram of a focal sphere with takeoff point positions projected to the ground surface;
Figure 10 is a flowchart of a method for designing a ground surface microseismic network;
Figure 11 is a flowchart of a method for monitoring microseismic events associated with a predefined volume;
Figures 12-13 are schematic diagrams of software components for monitoring microseismic events associated with a predefined volume according to an embodiment; and
Figure 14 illustrates a data processing device or system which can be used to implement the embodiments.

### DETAILED DESCRIPTION

The following description of the embodiments refers to the accompanying drawings. The same reference numbers in different drawings identify the same or similar elements. The following detailed description does not limit the invention. Instead, the scope of the invention is defined by the appended claims. Some of the following embodiments are discussed, for simplicity, with regard to the terminology and structure of configuring a microseismic network based on regular and homogeneous repartitioning of sensors in terms of sampling a focal sphere. However, the embodiments to be discussed next are not limited to these configurations, but may be extended to other arrangements as discussed later.

Reference throughout the specification to "one embodiment" or "an embodiment" means that a particular feature, structure or characteristic described in connection with an embodiment is included in at least one embodiment of the subject matter disclosed. Thus, the appearance of the phrases "in one embodiment" or "in an embodiment" in various places throughout the specification is not necessarily referring to the same embodiment. Further, the particular features, structures or characteristics may be combined in any suitable manner in one or more embodiments.

According to an embodiment, there is a method for configuring or designing a microseismic network based on regular and homogeneous repartitioning of sensors in terms of sampling a focal sphere. The embodiment comprises receiving seismic data recorded with three-dimensional receivers. The seismic data includes both radial and vertical components. The embodiment further comprises transforming the radial and vertical components into primary and ghost components (or energy). The speed of the S-waves in the near-surface is determined by measuring time differences between the primary and ghost wave fields and geometric considerations associated with the S-waves, as discussed later. Refracted and/or reflected waves may be used for this determination.

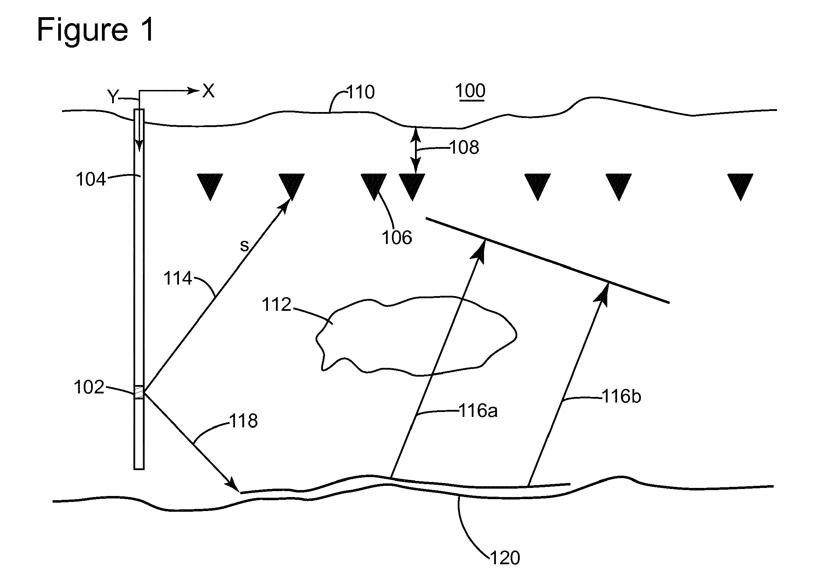

According to an embodiment illustrated in Figure 1, a seismic system 100 can include a seismic source 102 that might be provided in a well 104. The source may be any known source for delivering a perforation shot to the sample area. The perforation shots are used by the embodiments to calibrate the velocity model associated with microseismic monitoring. A plurality of receivers 106 are positioned at a predetermined depth 108 relative to a surface of the earth 110. The predetermined depth may be a distance larger than zero and smaller than the depth of the reservoir. The receivers may be three-component (3C) geophones or 4C, i.e., a 3C geophone and a hydrophone. However, other three-component receivers can be used. The reservoir or subsurface 112 to be monitored is located at a depth greater than the depth of the receivers 106.

In another embodiment, the system 100 includes 3C receivers buried at about twelve meters. The seismic data can be recorded for tens of days, for example, eighty days. The seismic data can be averaged to produce a single set. The seismic data can be used to show that the acquisition system 100 and survey design are ideally suited to obtain estimates of S-wave attenuation for the top soil with high spatial resolution. The top soil (near-surface) is considered to be that portion of the ground that is above the receivers 106. This top soil is sometimes called the weathering layer.

The speed of the S-waves in the near surface may be estimated from recording refracted S-waves. Figure 1 shows a direct S-wave 114, i.e., a wave that propagates from the source 102 directly to the receivers 106. Figure 1 also shows refracted S-waves 116a and 116b. The refracted S-waves 116a-b are a result of a down-going S-wave 118 that reaches a critical angle and gets refracted from a structure 120. It is noted that the direct S-wave 114 is recorded with a small offset (i.e., distance from the source to the receiver along X axis is small) while the refracted S-waves 116a-b are recorded with medium to large offsets.

To summarize, the embodiment for measuring near-surface attenuation uses buried 3C receivers that measures a wave field at two instances. Any seismic energy that is reflected, refracted or generated at a depth below the buried receiver array is recorded first as it passes through the plurality of receivers while propagating toward the earth's surface. This up-going primary energy is then reflected down at the free surface (it is assumed that the reflection coefficient of the free surface is -1) and recorded a second time as it propagates back down into the earth. This later, secondary arrival includes down-going, or ghost, energy.

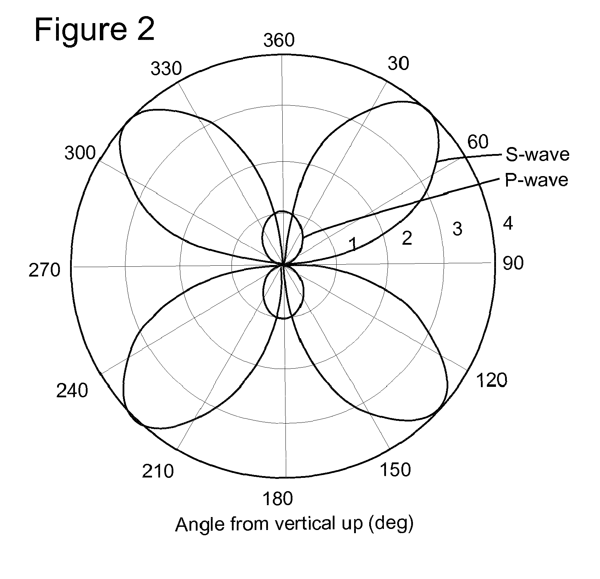

The seismic source for generating the seismic waves monitored in a microseismic monitoring embodiment in Figure 1 is the naturally generated seismic waves associated with the monitored area. However, a perforation shot with a dipole with a long axis oriented along a vertical Y direction will be used to describe wave properties. Dipole sources are highly directional and emit both P-waves and S-waves as shown in Figure 2. The radiation pattern is rotationally symmetric about the vertical axis. Maximum P-wave energy is emitted vertically while none is emitted horizontally. Maximum S-wave energy is emitted at a forty-five degree angle from vertical in both the upward and downward directions. No S-wave energy is emitted vertically or horizontally. Only S_{V} waves are generated and, overall, more S-wave energy is generated than P-wave energy. Upward- and downward-emitted energies have opposite polarities.

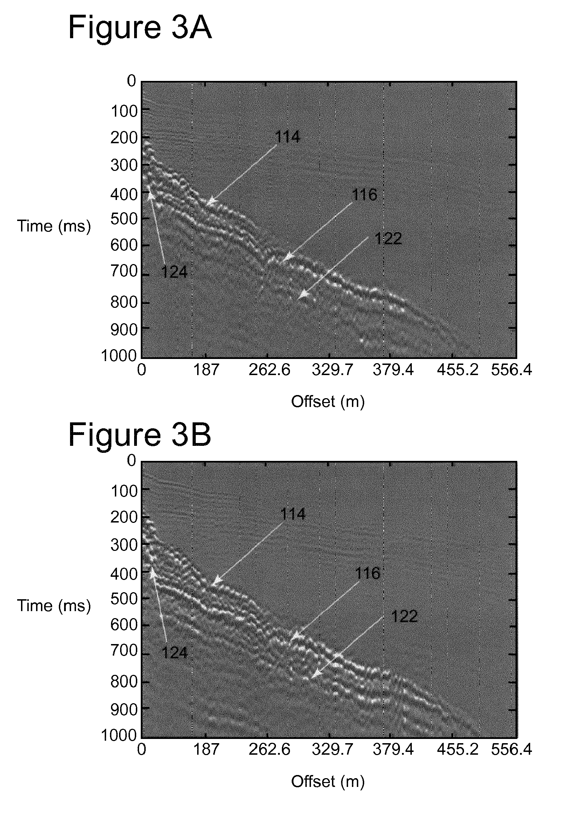

Representative vertical and radial component shot gathers calculated based on the data recorded by the receivers 106 and illustrated in Figures 3A and 3B show an abundance of coherent P-wave reflections as well as some coherent "first break" S-wave arrivals 114 and 116 that are followed mainly by incoherent or scattered S-wave noise. The lack of clear and abundant S-wave reflections is a consequence of the absence of vertically emitted S-waves in the source radiation pattern. The coherent first break S-wave event consists of two distinct arrivals. The first is the direct arrival from upward-emitted S-waves 114. The second one corresponds to the refracted S-waves 116a-b. The second arrival is due to the structure of the sources that emit most S-wave energy at forty-five degrees. Thus, it is expected that a large portion of the downward-emitted energy will reach critical angles at relatively limited offset and depth from the source. A structure 120 located below the sources is the possible candidate for producing the refraction S-waves 116a-b. Figures 3A and 3B also show the refracted ghost 122 and the direct ghost 124.

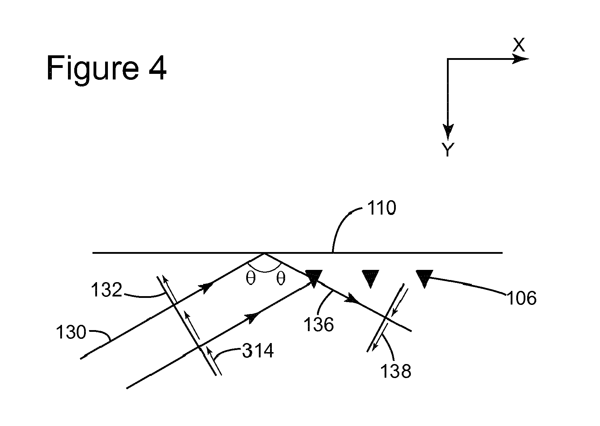

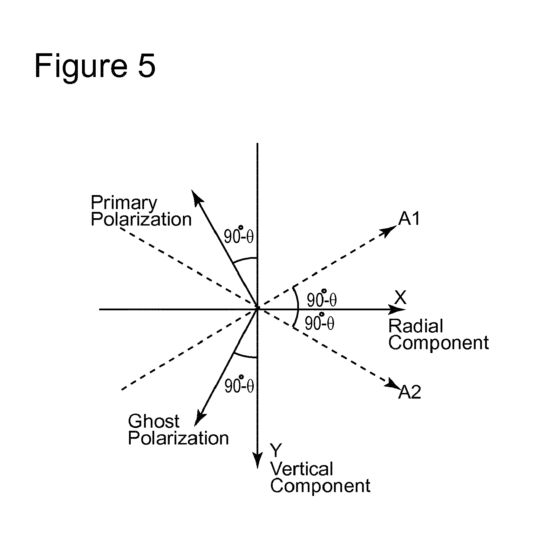

Having recorded the refracted S-waves (radial and vertical components) with the 3C receivers, the radial and vertical recorded components may be used to calculate primary and ghost components as discussed next. Figure 4 illustrates refracted S-waves 130 having a wave front 132 (plane waves) and a polarization 134 along the wave front 132. After reflection with angle "θ" on the surface 110, the ghost S-waves 136 has polarization 138. Figure 5 shows a relationship between the primary (130) and ghost (136) polarizations, relative to the X and Y axis, which corresponds to the radial and vertical components, respectively.

A microseismic network embodiment can be configured based on a regular and homogeneous repartition of sensors in terms of sampling a focal sphere. A microseismic network optimized according to an embodiment allows better detection, location and source characterization of seismic events. In general, a microseismic network is configured according to an embodiment by determining an optimal sampling of the focal sphere of potential microseismic events and associated take-off angle, and numerically propagating the associated rays to the surface for accurate sensor placement.

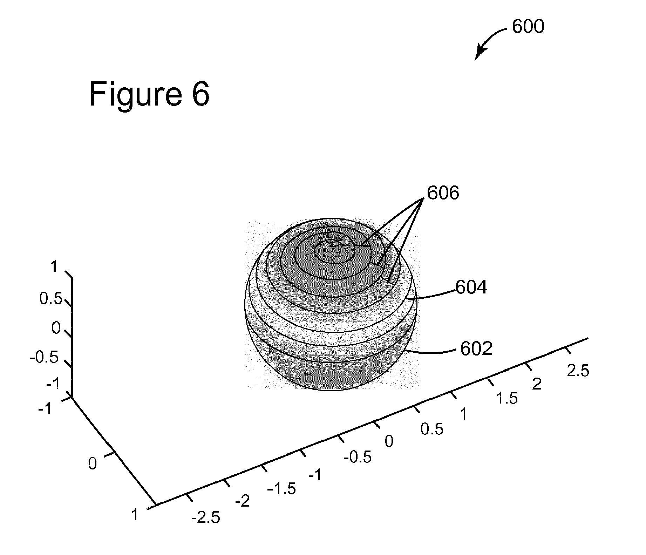

Looking now to Figure 6, based on the use of a sphere as a bounding sampling surface 602 of interest, there are few homogeneous sampling positions, i.e., a set of positions based on a regular sampling of latitudinal and longitudinal positions does not lead to a regular solid angle repartition. Accordingly, embodiments use a spherical helix 604 and a predetermined angular distance 606 between each horizontal parallel along the curve.

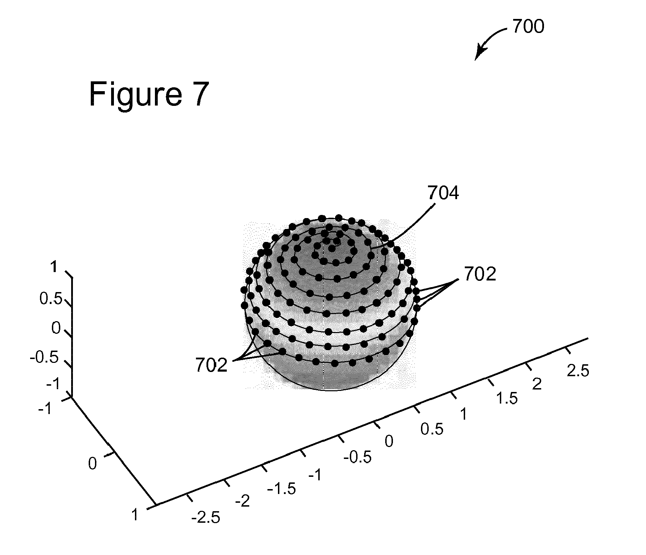

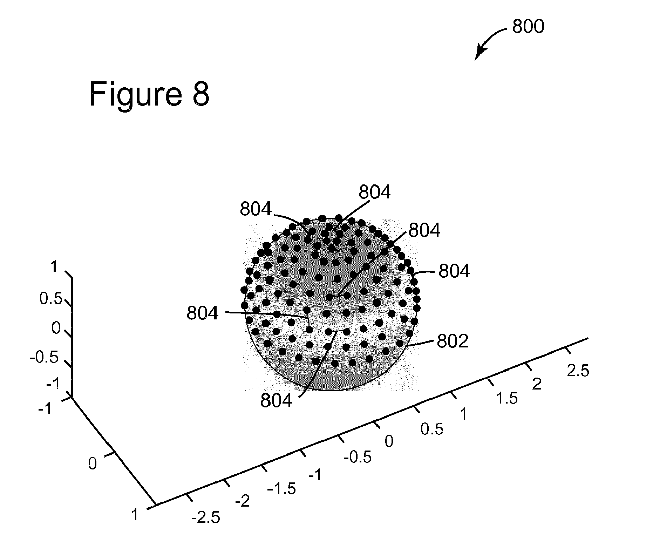

Next in the embodiment, as depicted in Figure 7, locations along the curve 704 with equivalent angular distance 702 are selected for use in determining sampling positions. Continuing with the embodiment and as depicted in Figure 8, a homogeneous repartition of positions 804 around the sphere 802 that are an equal distance from each other as plotted along a spherical helix depicts the positions for determining the take-off angles to propagate the velocity model toward the surface.

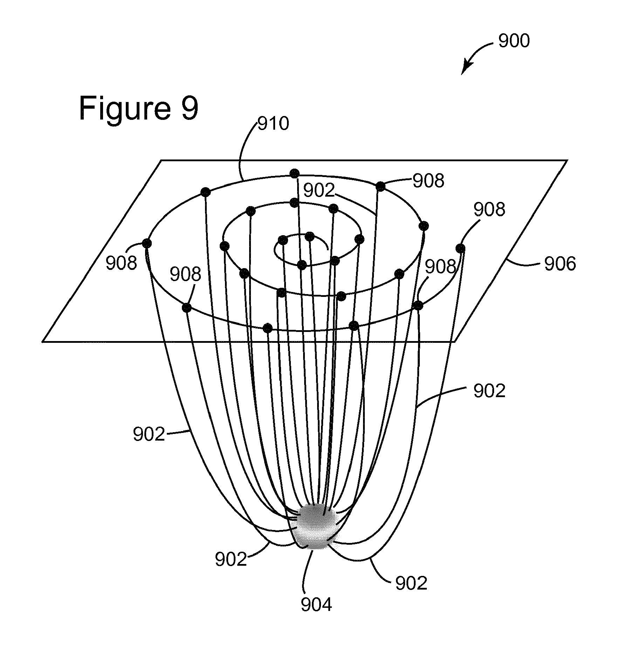

Looking now to Figure 9 of the embodiment, an optimal microseismic network is generated by projecting the take-off angles 902 from the spherical sampling surface 904 to the projected sample location 908 on the projected spiral 910 at the surface 906. It should be noted in the embodiment that the projected spiral 910 at the surface 904 is not a regular spiral because it is convolved by the propagation and accordingly is dependent on a velocity field. It should further be noted that the number of sample locations 908 on the surface 904 is directly linked to the angular aperture between each position and is preconfigured by the designer of the microseismic network, providing the capability to optimize the tradeoff between reliability, resolution, permitting complexity and cost of the microseismic network.

Continuing with the embodiment, determining a ray-path from a designed source position based on a given takeoff angle is accomplished with a ray tracing method. Ray tracing methods use the Snell-Descartes law to describe the propagation of any given wave. For example, if the earth is described by a velocity model characterized by velocities associated with depth, curvature of the ray is determined by the ratio of the different velocities of the different layers. Other propagation methods such as an Eikonal solver or a wavefront construction solver can be used but they are more complex, e.g., an Eikonal solver requires solving the Eikonal equation based on finite differences. The type of ray tracing method employed is based on a tradeoff between the added complexity of the method and the improvement in the sampled data.

The microseismic network resulting from the embodiment is sparse, with respect to the number of sample locations 908, i.e., required receivers, and does not require a regular grid of receivers at the surface 904. At each sample location 908 of the embodiment, deployed receivers can be a unique seismometer, a shallow buried array with subsurface strings of geophones or a group array with a plurality of geophones configured in a stacked arrangement. It should be noted in the embodiment that although the microseismic network samples a relatively small volume of potential seismic event occurrences, in the case of microseismic monitoring, e.g., a fracturing application, the expected seismic events reside in a small target volume wherein a designed and configured embodiment microseismic network is capable of detecting, locating and characterizing the expected events. It should further be noted that the embodiment is scalable based on the expected volume in which the seismic events will occur.

The previously described embodiments provide the capability to design an optimal representation of a microseismic network based on a focal sphere propagated to the surface. The microseismic network will provide optimal detections, locations and source characteristics of microseismic events. It should be noted in the embodiments that no bias is introduced by the microseismic network geometry. It should further be noted that operational cost and permitting issues are optimized.

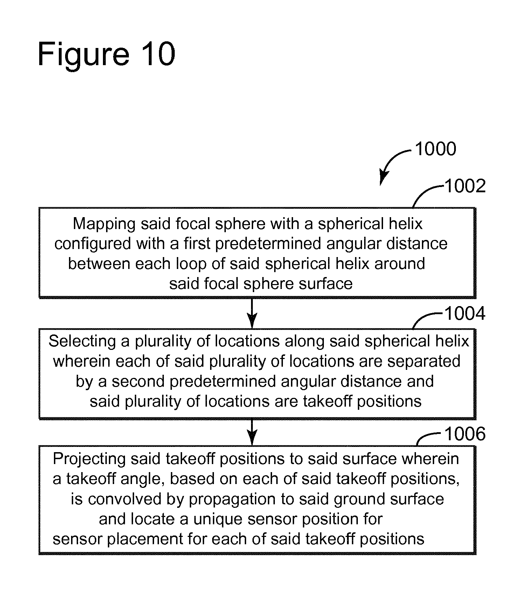

Looking now to Figure 10, a method embodiment for designing a ground surface microseismic network. The microseismic network method embodiment 1000 is based on a focal sphere bounding a desired volume where seismic events of interest will occur. The first step 1002 of the method embodiment 1000 describes mapping a focal sphere with a spherical helix. Continuing with the method embodiment 1000, each loop of the spherical helix is separated by a first predetermined angular distance.

Continuing with a second step 1004 of method embodiment 1000, a plurality of locations along the spherical helix is selected for use as takeoff positions. In another aspect of the method embodiment 1000, the plurality of locations is separated by a second predetermined angular distance. It should be noted in the method embodiment 1000 that the first predetermined angular distance and the second predetermined angular distance can be equal.

Next, at a third step 1006 of method embodiment 1000, the previously described takeoff positions are projected to the ground surface by computing a takeoff angle based on the takeoff position on the spherical helix. It should be noted in the method embodiment that the projection comprises convolving, by propagation, a takeoff position to the ground surface to locate a unique position for sensor placement.

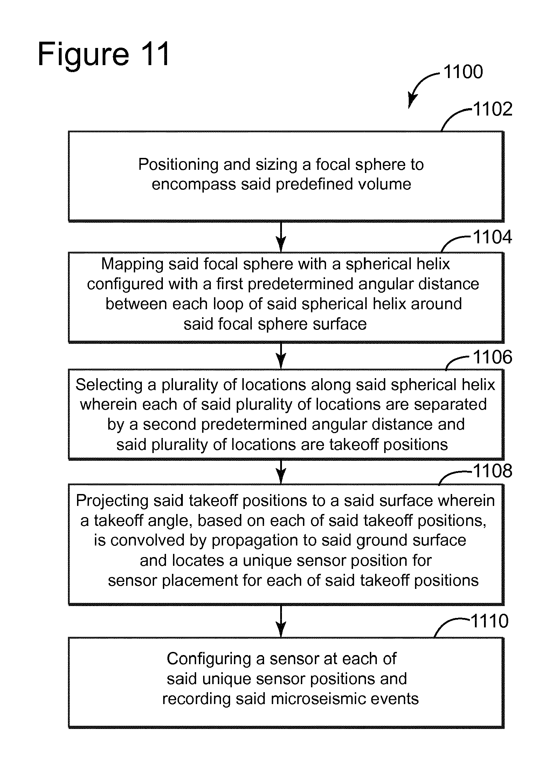

Looking now to Figure 11, a method embodiment 1100m for monitoring microseismic events associated with a predefined volume is depicted. Starting at step 1102 of the method embodiment 1100, a focal sphere is positioned and sized such that it encompasses the predefined volume.

Next, step 1104 of the embodiment 1100 describes mapping the focal sphere with a spherical helix. Continuing with the method embodiment 1100, each loop of the spherical helix is separated by a first predetermined angular distance.

Continuing with step 1106 of method embodiment 1100, a plurality of locations along the spherical helix is selected for use as takeoff positions. In another aspect of the method embodiment 1100, the plurality of locations is separated by a second predetermined angular distance. It should be noted in the method embodiment 1100 that the first predetermined angular distance and the second predetermined angular distance can be equal.

Next, at step 1108 of method embodiment 1100, the previously described takeoff positions are projected to the ground surface by computing a takeoff angle based on the takeoff position on the spherical helix. It should be noted in the method embodiment that the projection comprises convolving, by propagation, a takeoff position to the ground surface to locate a unique position for sensor placement.

Continuing with step 1110 of the method embodiment 1100, a seismic sensor is configured at each of the unique sensor positions and the plurality of seismic sensors record microseismic events as they occur. It should be noted that the microseismic network can record active seismic events, e.g., perforation shots for uses comprising calibrating the velocity model.

In a variant of the described embodiments, seismic sensors associated with the embodiments can include but are not limited to seismometers, a shallow buried array with sub-surface strings of geophones and a group array with a plurality of stacked geophones. It should be noted in the embodiments that combinations of the described sensor types or other sensor types not described. Looking to another variant of the embodiments, the focal sphere bounding the desired bottom can be in the strata underlying the sea bottom with the ground surface defining the sea bottom.

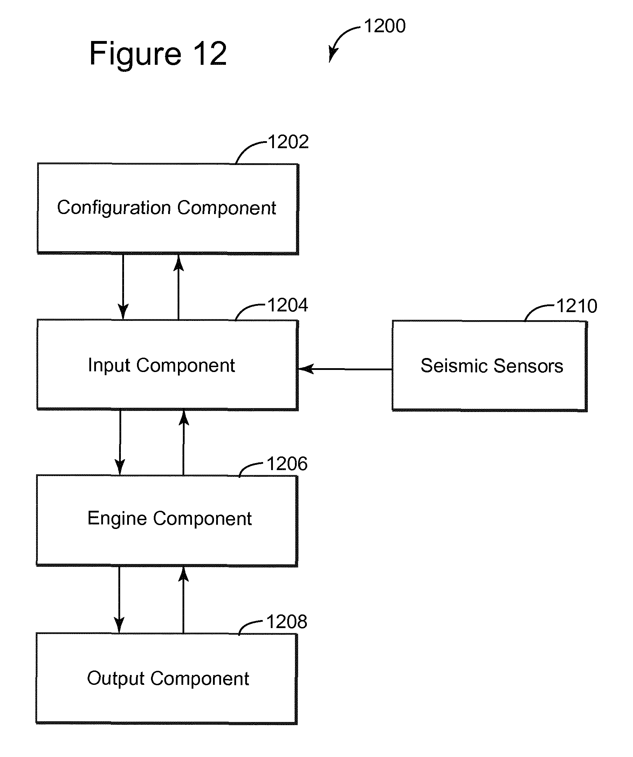

Looking now to Figure 12, a schematic diagram of an embodiment node 1200 for monitoring microseismic events associated with a predefined spherical volume is depicted. The embodiment node 1200 comprises a configuration component 1202, an input component 1204, an engine component 1206, an output component 1208 and seismic sensors 1210. Continuing with the embodiment node 1200, the configuration component 1202 provides the ability to generate a focal sphere of a desired size and position the focal sphere such that it encompasses a volume containing the microseismic events of interest.

Next in the embodiment node 1200, the input component 1204 provides the ability to monitor for and collect seismic events occurring within the focal sphere. It should be noted in the embodiment node 1200 that the input component collects the seismic event data from the seismic sensors 1210 positioned according to these embodiments. Continuing with the embodiment node 1200, the engine component 1206 provides the capability process the seismic event data collected by the input component 1204. It should be noted in the embodiment node 1200 that processing the seismic event data by the engine component 1206 comprises locating the seismic events, recording the seismic events and source characterization of the seismic events. Next in the embodiment node 1200, the output component 1208 provides the capability to output seismic data associated with a microseismic network without any bias introduced by the network geometry.

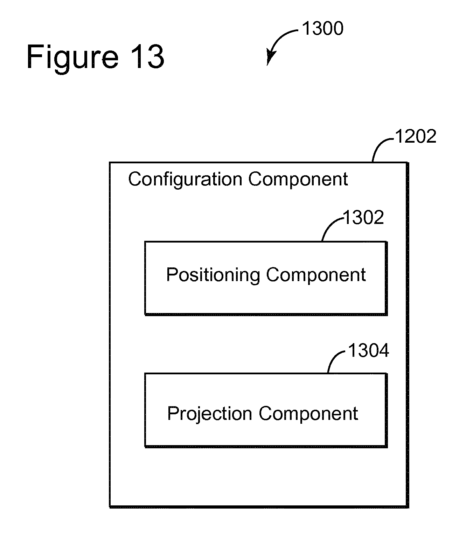

Looking now to Figure 13, another embodiment node 1300 of a configuration component 1202 is depicted. The embodiment node 1300 comprises a configuration component 1202 further comprising a positioning component 1302 and a projection component 1304. Continuing with the embodiment node 1300, the positioning component 1302 provides the capability to design a focal sphere of a size suitable for the seismic sample volume of interest. Further in the embodiment node 1300, the positioning component 1302 provides the capability to position the previously sized focal sphere at a location where the volume of the focal sphere encloses the seismic sample volume of interest.

Next in the embodiment node 1300, the projection component 1304 provides the capability to wrap the focal sphere with a spherical helix where each loop of the spherical helix is separated from the previous loop of the spherical helix by a first predetermined angular distance. Continuing with the embodiment node 1300, the projection component 1304 provides the capability to select positions along the spherical helix for takeoff positions where the takeoff positions are separated along the spherical helix by a second predetermined angular distance. It should be noted in the embodiment node 1300 that the first predetermined angular distance and the second predetermined angular distance can be equal.

Continuing with the embodiment node 1300, the projection component 1304 provides the capability project the helix to the ground surface by convolving the takeoff points based on the takeoff angles associated with the takeoff points. It should be noted in the embodiment node 1300 that the projection of the helix on the surface is not a regular spiral based on convolving by propagation.

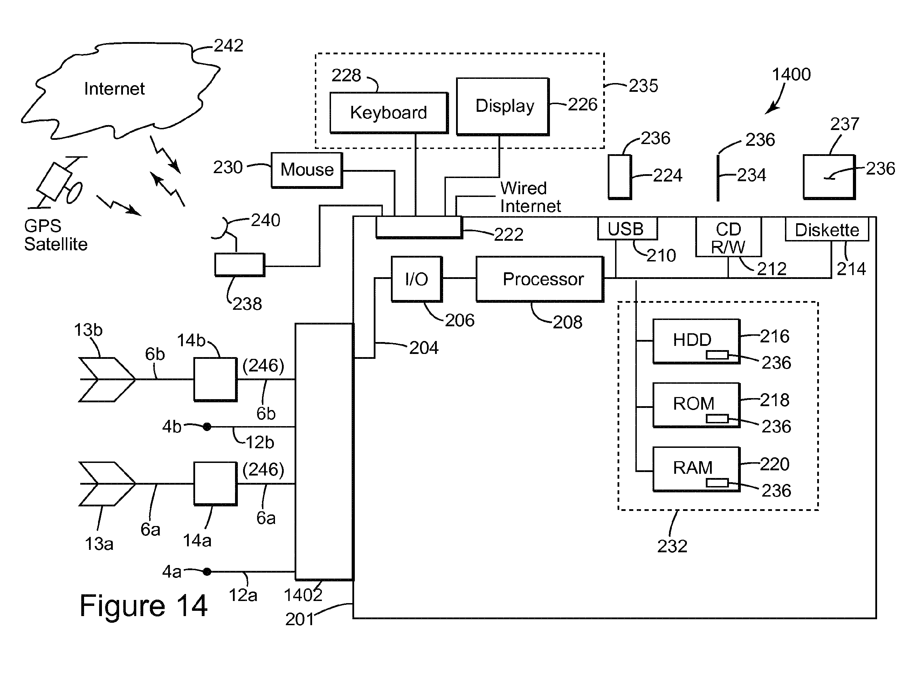

The computing device(s) or other network nodes involved in designing an optimal microseismic network as set forth in the above described embodiments may be any type of computing device capable of processing and communicating seismic data associated with microseismic monitoring. An example of a representative computing system capable of carrying out operations in accordance with these embodiments is illustrated in Figure 14. System 1400 includes, among other items, server 201, source/receiver interface 1402, internal data and/or communications bus (bus) 204, processor(s) 208 (those of ordinary skill in the art can appreciate that in modern server systems, parallel processing is becoming increasingly prevalent, and whereas a single processor would have been used in the past to implement many or at least several functions, it is more common currently to have a single dedicated processor for certain functions (e.g., digital signal processors) and therefore could be several processors, acting in serial and/or parallel, as required by the specific application), universal serial bus (USB) port 210, compact disk (CD)/digital video disk (DVD) read/write (R/W) drive 212, floppy diskette drive 214 (though less used currently, many servers still include this device), and data storage unit 232.

Data storage unit 232 itself can comprise hard disk drive (HDD) 216 (these can include conventional magnetic storage media, but, as is becoming increasingly more prevalent, can include flash drive-type mass storage devices 224, among other types), ROM device(s) 218 (these can include electrically erasable (EE) programmable ROM (EEPROM) devices, ultra-violet erasable PROM devices (UVPROMs), among other types), and random access memory (RAM) devices 220. Usable with USB port 210 is flash drive device 224, and usable with CD/DVD R/W device 212 are CD/DVD disks 234 (which can be both read and write-able). Usable with diskette drive device 214 are floppy diskettes 237. Each of the memory storage devices, or the memory storage media (216, 218, 220, 224, 234, and 237, among other types), can contain parts or components, or in its entirety, executable software programming code (software) 236 that can implement part or all of the portions of the method described herein. Further, processor 208 itself can contain one or different types of memory storage devices (most probably, but not in a limiting manner, RAM memory storage media 220) that can store all or some of the components of software 236.

In addition to the above described components, system 200 also comprises user console 234, which can include keyboard 228, display 226, and mouse 230. All of these components are known to those of ordinary skill in the art, and this description includes all known and future variants of these types of devices. Display 226 can be any type of known display or presentation screen, such as liquid crystal displays (LCDs), light emitting diode displays (LEDs), plasma displays, cathode ray tubes (CRTs), among others. User console 235 can include one or more user interface mechanisms such as a mouse, keyboard, microphone, touch pad, touch screen, voice-recognition system, among other inter-active inter-communicative devices.

User console 234, and its components if separately provided, interface with server 201 via server input/output (I/O) interface 222, which can be an RS232, Ethernet, USB or other type of communications port, or can include all or some of these, and further includes any other type of communications means, presently known or further developed. System 200 can further include communications satellite/global positioning system (GPS) transceiver device 238, to which is electrically connected at least one antenna 240 (according to an exemplary embodiment, there would be at least one GPS receive-only antenna, and at least one separate satellite bi-directional communications antenna). System 200 can access internet 242, either through a hard wired connection, via I/O interface 222 directly, or wirelessly via antenna 240, and transceiver 238.

Server 201 can be coupled to other computing devices, such as those that operate or control the equipment via one or more networks. Server 201 may be part of a larger network configuration as in a global area network (GAN) (e.g., internet 242), which ultimately allows connection to various landlines.

According to further exemplary embodiments, user console 235 provides a means for personnel to enter commands and configuration into system 200 (e.g., via a keyboard, buttons, switches, touch screen and/or joy stick). Display device 226 can be used to show: visual representations of acquired data; receiver 14 status information; survey information; and other information important to the microseismic monitoring process.

Bus 204 allows a data pathway for items such as: the transfer and storage of data that originate from the receivers; for processor 208 to access stored data contained in data storage unit memory 232; for processor 208 to send information for visual display to display 226; or for the user to send commands to system operating programs/software 236 that might reside in either the processor 208 or the source and receiver interface unit 202.

System 200 can be used to implement the methods described above associated with designing an optimal microseismic network according to an embodiment. Hardware, firmware, software or a combination thereof may be used to perform the various steps and operations described herein. According to an embodiment, software 236 for carrying out the above discussed steps can be stored and distributed on multi-media storage devices such as devices 216, 218, 220, 224, 234, and/or 237 (described above) or other form of media capable of portably storing information (e.g., universal serial bus (USB) flash drive 426). These storage media may be inserted into, and read by, devices such as the CD-ROM drive 414, the disk drive 412, among other types of software storage devices.

The disclosed embodiments provide a server node, and a method for designing optimal microseismic monitoring networks. It should be understood that this description is not intended to limit the invention. On the contrary, the embodiments are intended to cover alternatives, modifications and equivalents, which are included in the spirit and scope of the invention. Further, in the detailed description of the embodiments, numerous specific details are set forth in order to provide a comprehensive understanding of the invention. However, one skilled in the art would understand that various embodiments may be practiced without such specific details.

Although the features and elements of the present embodiments are described in the embodiments in particular combinations, each feature or element can be used alone without the other features and elements of the embodiments or in various combinations with or without other features and elements disclosed herein. The methods or flow charts provided in the present application may be implemented in a computer program, software, or firmware tangibly embodied in a computer-readable storage medium for execution by a general purpose computer or a processor.

This written description uses examples of the subject matter disclosed to enable any person skilled in the art to practice the same, including making and using any devices or systems and performing any incorporated methods. The patentable scope of the subject matter is defined by the claims, and may include other examples that occur to those skilled in the art. Such other examples are intended to be within the scope of the claims.

## Claims

1. A method, stored in a memory and executing on a processor, for configuring a ground surface microseismic network based on a focal sphere bounding a desired volume of seismic events, said method comprising:
mapping (1000) said focal sphere with a spherical helix configured with a first predetermined angular distance between each loop of said spherical helix around said focal sphere surface;
selecting (1002) a plurality of locations along said spherical helix wherein each of said plurality of locations are separated by a second predetermined angular distance and said plurality of locations are takeoff positions; and
projecting (1004) said takeoff positions to said surface, wherein a takeoff angle, based on each of said takeoff positions is convolved by propagation to said ground surface to determine a sensor position for sensor placement for each of said takeoff positions.

2. The method of claim 1, wherein said first predetermined angular distance is equal to said second predetermined angular distance.

3. The method of claim 1, wherein said propagation is dependent on a velocity field.

4. The method of claim 1, further comprising placing a sensor at each of said unique sensor positions.

5. The method of claim 1, wherein said sensor is a seismometer.

6. The method of claim 1, wherein said sensor is a shallow buried array with sub-surface strings of geophones.

7. The method of claim 1, wherein said sensor is a group array with a plurality of stacked geophones.

8. The method of claim 1, wherein said ground surface is onshore.

9. The method of claim 1, wherein said ground surface is offshore sea bottom.

10. A method, stored in a memory and executing on a processor, for monitoring microseismic events associated with a predefined volume, said method comprising:
positioning (1102) and sizing a focal sphere to encompass said predefined volume;
mapping (1104) said focal sphere with a spherical helix configured with a first predetermined angular distance between each loop of said spherical helix around said focal sphere surface;
selecting (1106) a plurality of locations along said spherical helix wherein each of said plurality of locations are separated by a second predetermined angular distance and said plurality of locations are takeoff positions;
projecting (1108) said takeoff positions to said surface, wherein a takeoff angle based on each of said takeoff positions is convolved by propagation to said ground surface to determine a sensor position for sensor placement for each of said takeoff positions; and
configuring (1110) a sensor at each of said unique sensor positions and recording said microseismic events.

11. A node for monitoring microseismic events associated with a predefined spherical volume, said node comprising:
a plurality of seismic sensors (1210);
one or more processors (208) configured to execute computer instructions and a memory configured to store said computer instructions wherein said computer instructions further comprise:
a configuration component (1202) for determining the positions at the ground surface for placing said plurality of seismic sensors (1210);
an input component (1204) for collecting seismic data from said plurality of seismic sensors (1210);
an engine component (1206) for processing said seismic data; and
an output component (1208) for outputting processed seismic data.

12. The node of claim 11, wherein said plurality of seismic sensors are seismometers.

13. The node of claim 11, wherein said plurality of seismic sensors are a shallow buried array with subsurface strings of geophones.

14. The node of claim 11, wherein said plurality of seismic sensors are a group array with a plurality of stacked geophones.

15. The node of claim 11, wherein said configuration component further comprises a positioning component for determining a plurality of takeoff positions associated with said predefined spherical volume and disposed along a spherical helix on a surface of said predefined spherical volume.
